# EUROPEAN PATENT SPECIFICATION

(11) **EP 3 376 538 B1**
(45) Date of publication and mention of the grant of the patent: **09.09.2020**
(21) Application number: 17161032.2
(22) Date of filing: 15.03.2017
(51) Int. Cl.: H01L 25/07, H01L 23/00

(54) **SEMICONDUCTOR ARRANGEMENT WITH CONTROLLABLE SEMICONDUCTOR ELEMENTS**
HALBLEITERANORDNUNG MIT STEUERBAREN HALBLEITERELEMENTEN
AGENCEMENT SEMI-CONDUCTEUR AVEC DES ÉLÉMENTS À SEMI-CONDUCTEUR COMMANDABLES

(43) Date of publication of application: 19.09.2018
(73) Proprietor: Infineon Technologies AG, 85579 Neubiberg (DE)
(72) Inventor: MÜLLER, Christian Robert, 97421 Schweinfurt (DE)
(74) Representative: Westphal, Mussgnug & Partner Patentanwälte mbB

(56) References cited:
- JP-A- 2003 007 969
- CZERNY B ET AL: "Thermo-mechanical analysis of bonding wires in IGBT modules under operating conditions", MICROELECTRONICS AND RELIABILITY, vol. 52, no. 9, 1 September 2012 (2012-09-01), pages 2353-2357, XP028942028, ISSN: 0026-2714, DOI: 10.1016/J.MICROREL.2012.06.081

## Description

### TECHNICAL FIELD

The instant disclosure relates to semiconductor arrangements having controllable semiconductor elements.

### BACKGROUND

Semiconductor arrangements like power semiconductor modules or the like are widely used in automotive, industrial, and consumer electronic applications for driving loads, converting power, or the like. Such a semiconductor arrangement may include at least one controllable semiconductor element having a load path formed between a first load electrode (e.g. a source electrode or an emitter electrode) and a second load electrode (e.g. a drain electrode and a collector electrode), and a control electrode (e.g. a gate or base electrode). In order to increase the arrangement's ampacity, the load paths of two or more of such controllable semiconductor elements may be electrically connected in parallel and, in the ideal case, operated synchronously by feeding a common control voltage (e.g. provided by a controller) to the individual controllable semiconductor elements using electrical lines, of which one electrically connects the first load electrodes and the other electrically connects the control electrodes.

Because the switching state of a controllable semiconductor element, e.g. whether the load path is electrically conducting or blocking, depends on its individual control voltage, i.e. on the difference between the electric potentials of the control electrode and the first load electrode of the corresponding controllable semiconductor element, a large current flowing through the line electrically connecting the first load electrodes can, in combination with the inevitable ohmic resistance and/or inductance of that line, lead to significantly different electric potentials at the first load electrodes of the different controllable semiconductor elements. Therefore, there may be situations in which the switching states of different controllable semiconductor elements significantly differ. As a result, the electric load current through the controllable semiconductor elements and, therefore, the thermal and electrical load caused by the electric load current are unevenly distributed among the controllable semiconductor elements. Hereby, the lifetime of the more heavily burdened controllable semiconductor elements may be reduced. Further, significantly different switching states may also be caused by undesired interbody-oscillations between the controllable semiconductor elements.
The document "Thermo-mechanical analysis of bonding wires in IGBT modules under operating conditions" of Czemy B. et al. in Microelectronics and Reliability, vol. 52, no. 9, 1 September 2012, pp. 2353 - 2357, discloses to use Laser Doppler Vibrometer measurements and thermal imaging to determine the temperature-dependent deformations of bond wires at different frequencies under operation conditions. There are disclosed IGBTs and diodes that are soldered on the collector side to a DCB substrate. The emitter connections are realized by eight bond wires ultrasonically bonded to each IGBT and sixteen to each diode. Two additional bond wires connect the emitter metallization of the IGBT and diode dies directly for the purpose of voltage stabilization.
Document JP 2003 007969 A discloses a power semiconductor module for power conversion comprising an insulating substrate, an electrode wiring layer provided on one major surface thereof, and a switching element and a circulation diode mounted on the electrode wiring layer wherein thermal resistance against diffusion of heat generated from the circulation diode is lower than thermal resistance against diffusion of heat generated from the switching element. The circulation diode is mounted on the electrode wiring layer closer to the center than the switching element or head is dissipated upward by a heat dissipation lead.

The aforementioned documents disclose a device of the type as defined in claim 1, but none of them discloses that a fourth terminal serving to provide a reference potential is electrically connected to all first load electrodes solely via the first electrode of the freewheeling element and the respective separate first lines.

The inventor sees a need for a semiconductor assembly that reduces or prevents at least one of the drawbacks that can occur when the load paths of two or more controllable semiconductor elements are operated in parallel.

### SUMMARY

The semiconductor arrangement includes a multiplicity of identical controllable semiconductor elements, a freewheeling element, a first terminal, a second terminal, a third terminal, and a fourth terminal. Each of the multiplicity of controllable semiconductor elements includes a first load electrode, a second load electrode and a control electrode. The freewheeling element includes a first electrode and a second electrode. The first terminal is electrically connected to the first load electrodes of the multiplicity of controllable semiconductor elements, the second terminal is electrically connected to the second load electrodes of the multiplicity of controllable semiconductor elements and to the second electrode of the freewheeling element, the third terminal is electrically connected to the control electrodes of the multiplicity of controllable semiconductor elements, and the fourth terminal is electrically connected to the first electrode of the freewheeling element. The first electrode of the freewheeling element is electrically connected to the first load electrode of each of the multiplicity of controllable semiconductor elements via an individual one of a multiplicity of first lines. The fourth terminal serves to provide an electric reference potential, and the electric reference potential is transferred to all first load electrodes solely via the first electrode of the freewheeling element and the respective separate first lines.

The invention may be better understood with reference to the following drawings and the description. The components in the figures are not necessarily to scale, emphasis instead being placed upon illustrating the principles of the invention.

Moreover, in the figures, like referenced numerals designate corresponding parts throughout the different views.

### BRIEF DESCRIPTION OF THE DRAWINGS

Figure 1 is a circuit diagram of an exemplary semiconductor arrangement with two controllable semiconductor elements.
Figure 2 is a top view illustrating another exemplary semiconductor arrangement.
Figure 3 is a top view illustrating an enlarged section A of the semiconductor arrangement of Figure 2.
Figure 4 is a cross-sectional side view of the section A in a cross-sectional plane E-E shown in Figure 3.
Figure 5 is a top view illustrating another exemplary semiconductor arrangement.
Figure 6 is a top view illustrating another exemplary semiconductor arrangement.
Figure 7 is a top view illustrating another exemplary semiconductor arrangement.
Figure 8 is a top view illustrating another exemplary semiconductor arrangement.

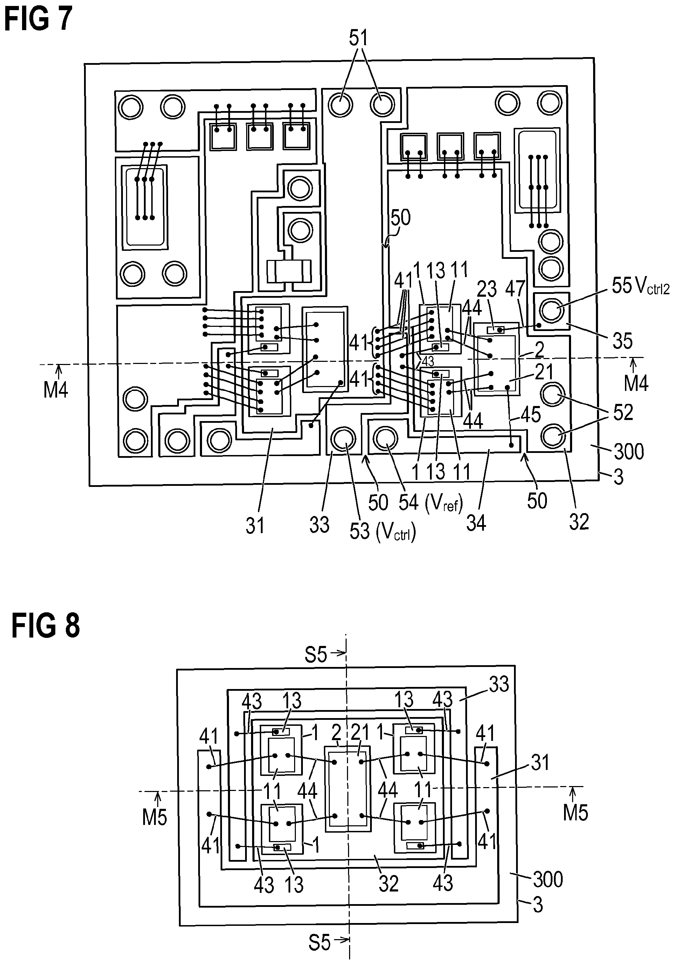

The arrangement depicted in Fig. 8 does not show that a fourth terminal for providing a reference voltage is electrically connected to all first load electrodes solely via the first electrode of the freewheeling element and the respective separate first lines, as claimed. This arrangement is merely considered useful for understanding the present invention.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. As well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line as described herein may be a single electrically conductive element, or include at least two individual electrically conductive elements connected in series and/or parallel. Electrical lines may include metal and/or semiconductor material, and may be permanently electrically conductive (i.e., non-switchable). An electrical line may have an electrical resistivity that is independent from the direction of a current flowing through it. A semiconductor body as described herein may be made from (doped) semiconductor material and may be a semiconductor chip or be included in a semiconductor chip. A semiconductor body has electrically connecting pads and includes at least one semiconductor element with electrodes. The pads are electrically connected to the electrodes which includes that the pads are the electrodes and vice versa.

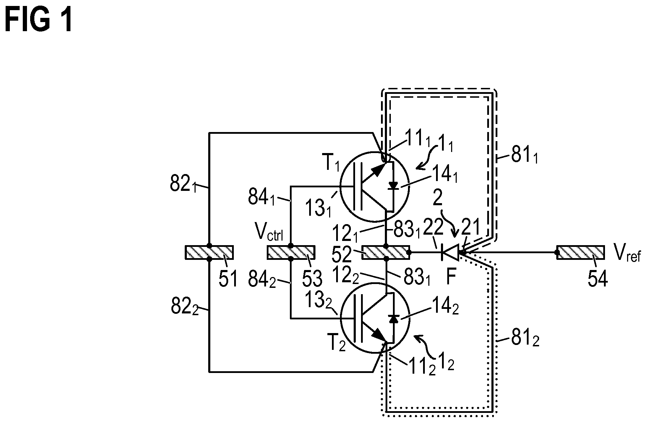

Referring to Figure 1, an exemplary semiconductor arrangement includes a multiplicity (here: two) of identical controllable semiconductor elements T₁ and T₂ (also referred to as controllable semiconductor elements T) such as, e.g., insulated gate bipolar transistors, a freewheeling element F (e.g., a diode), a first terminal 51, a second terminal 52, a third terminal 53, and a fourth terminal 54. Each of the two controllable semiconductor elements T₁ and T₂ includes a first load electrode 11₁, 11₂ (also referred to as load electrodes 11) such as an emitter; a second load electrode 12₁ and 12₂ (also referred to as load electrodes 12) such as a collector, and a control electrode 13₁ and 13₂ (also referred to as control electrodes 13) such as a gate. The freewheeling element F includes a first electrode 21, and a second electrode 22. The first terminal 51 is electrically connected to the first load electrodes 11₁ and 11₂ of the multiplicity of controllable semiconductor elements T₁ and T₂, the second terminal 52 is electrically connected to the second load electrodes 12₁ and 12₂ of the multiplicity of controllable semiconductor elements T₁ and T₂ and to the second electrode 22 of the freewheeling element F, and the third terminal 53 is electrically connected to the control electrodes 13₁ and 13₂ of the multiplicity of controllable semiconductor elements T₁ and T₂. The first electrode 21 of the freewheeling element F is electrically connected to the first load electrodes 11₁ and 11₂ of each of the multiplicity of controllable semiconductor elements T₁ and T₂ via an individual one of a multiplicity of separate first lines 81₁ and 81₂ (also referred to as lines 81). The separate lines 81₁ and 81₂ between the first electrode 11₁ and 11₂ allow for an electrically symmetrical design. Symmetrical lines 82₁ and 82₂ (also referred to as 82) may be used to connect the electrodes 11₁ and 11₂ to terminal 51. Symmetrical lines 83₁ and 83₂ (also referred to as lines 83) may be used to connect the electrodes 12₁ and 12₂ to terminal 52. Symmetrical lines 84₁ and 84₂ (also referred to as lines 84) may be used to connect the electrodes 13₁ and 13₂ to terminal 53.

An electrically symmetrical design provides identical voltage and current transfers over the respective lines so that, for example, identical synchronous voltage impulses input at one end of the lines appear at the same time and in the same shape at the end of the lines. For example, the individual first lines 81₁ and 81₂ may exhibit at least one of identical ohmic behaviors, identical inductive behaviors, and identical capacitive behaviors. This may be achieved, e.g., if the individual first lines 81₁ and 81₂ are wires of identical lengths, identical cross sectional areas, and identical materials. If the terminal 54 (e.g., an auxiliary emitter) is connected to the first electrode 21 of the freewheeling element F, a (control) voltage between the fourth terminal 54 and the third terminal 53 is transmitted to the control (third) electrodes of the individual controllable semiconductor elements T₁ and T₂ undistorted (undelayed), or at least with reduced respective distortion. Thus, the symmetrical design improves the transmission characteristics not only of the load circuit but also of the control circuit of the semiconductor arrangement. Additionally, the electrical connection between the second terminal 52 and the second electrodes 12₁ and 12₂ of the controllable semiconductor elements T₁ and T₂, and/or between third terminal 53 and the second electrodes 12₁ and 12₂ of the controllable semiconductor elements T₁ and T₂ may have an electrically symmetrical design.

The controllable semiconductor elements T₁ and T₂ may be included in discrete semiconductor bodies 1₁ and 1₂ (also referred to as semiconductor bodies 1) and include intrinsic freewheeling elements 14₁ and 14₂ (also referred to as 14) such as s body diodes, which are electrically connected between the first load electrodes 11₁ and 11₂ and the second load electrodes 12₁ and 12₂ of the controllable semiconductor element T₁ and T₂. The freewheeling element F may have a forward voltage that is greater than the forward voltage of the freewheeling element F (e.g., a diode). In this case the freewheeling element F is the element that provides the freewheeling and that is not one of the body diodes, e.g., if the body diodes are not suitable for a certain freewheeling purpose. The freewheeling element F may be included in another discrete semiconductor body 2.

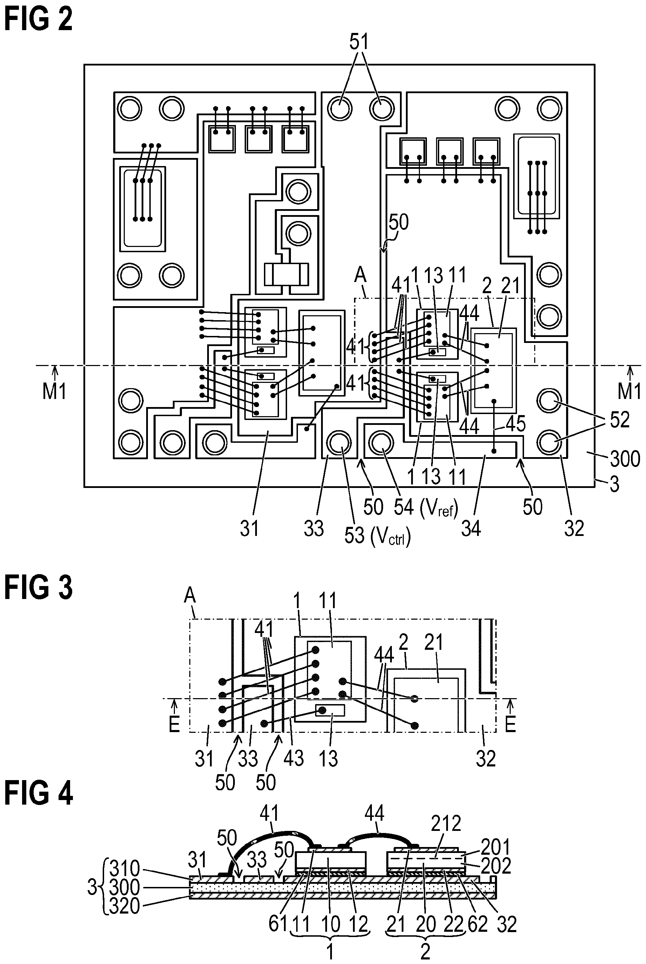

Figure 2 schematically illustrates a semiconductor arrangement that includes an exemplary assembled electrically insulated carrier 3, e.g. a circuit board, a substrate or switch plate. The semiconductor arrangement may include a circuit as illustrated in Figure 1. Figure 3 shows an enlarged view of a section A of Figure 2, and Figure 4 shows a cross-section of that section A in a sectional plane E-E. As shown in Figures 2 to 4, the semiconductor arrangement may include, disposed in each case on the electrically insulated carrier 3 (e.g. on the same surface of the electrically insulated carrier 3), the two first semiconductor bodies 1 and the one second semiconductor body 2. Each of the first semiconductor bodies 1 includes an individual one of the multiplicity of controllable semiconductor elements T (e.g., semiconductor elements T may correspond to semiconductor elements T₁ and T₂ shown in Figure 1). The first load electrode 11, the second load electrode 12 and the control electrode 13 of the controllable semiconductor element T may also be electrodes of the corresponding first semiconductor body 1. Further, the second semiconductor body 2 includes the freewheeling element F. The first electrode 21 and the second electrode 22 of the freewheeling element F may also be electrodes (pads) of the second semiconductor body 2. All first semiconductor bodies 1 may be structurally identical, e.g., of an identical construction with identical electrical properties. The construction of the second semiconductor body 2 may be different from the construction of each of the first semiconductor bodies 1. In the present example, no further controllable semiconductor element is provided in the semiconductor arrangement that has a first load electrode electrically connected to the first terminal 51, a second load electrode electrically connected to the first terminal 52 and a control electrode electrically connected to the third terminal 53.

As illustrated in Figure 4, each first semiconductor body 1 includes a semiconductor layer 10 and the first load electrode 11, the second load electrode 12 and the control electrode 13 of the controllable semiconductor element T integrated in the first semiconductor body 1. The second semiconductor body 2 includes a semiconductor layer 20 and the first electrode 21 and the second electrode 22 of the freewheeling element F integrated in the second semiconductor body 2. The semiconductor layer 10 may include a monocrystalline or substantially monocrystalline semiconductor material, e.g., silicon, silicon carbide, gallium nitride, gallium arsenide, aluminum gallium arsenide, or any other semiconductor material that can be used for semiconductor devices, and may have one or more semiconductor regions doped with electrically active dopants, i.e. with dopants causing the corresponding semiconductor region to be n-doped or p-doped. For example, the semiconductor layer 10 may include at least one pn-junction formed between a p-doped semiconductor region and an n-doped semiconductor region. In other constructions, e.g. in certain HEMTs (High Electron Mobility Transistor), however, the semiconductor layer 10 may be free of pn-junctions and/or free of electrically active dopants.

The design of the semiconductor layer 20 may be chosen independently from the design of the first semiconductor bodies 1. For instance, the semiconductor layer 20 may include a monocrystalline or substantially monocrystalline semiconductor material, e.g., silicon, silicon carbide, gallium nitride, gallium arsenide, aluminum gallium arsenide, or any other semiconductor material that can be used for semiconductor devices, and may have one or more semiconductor regions doped with electrically active dopants, i.e. with dopants causing the corresponding semiconductor region to be n-doped or p-doped. In other designs, however, the second semiconductor body 20 may be free of pn-junctions (e.g. in certain HEMTs or Schottky-diodes) and/or free of electrically active dopants (e.g. in certain HEMTs).

As described above, each of the first semiconductor bodies 1 includes an individual one of the multiplicity of identical controllable semiconductor elements T. Examples of suitable identical controllable semiconductor elements T are, without being restricted to, unipolar or bipolar transistors, thyristors, or any other controllable semiconductor elements. In case of transistors, the identical controllable semiconductor elements may be, e.g., IGFETs (Insulated Gate Field Effect Transistors) like MOSFETs (Metal Oxide Semiconductor Field-Effect Transistors) or IGBTs (Insulated Gate Bipolar Transistors; e.g. reverse conducting IGBTs), or JFETs (Junction Field Effect Transistors), HEMTs, BIPs (Bipolar Transistors), or any other transistors.

Each of the identical controllable semiconductor elements T has a load path formed between the first load electrode 11 and the second load electrode 12, and a control input connected to the control electrode 13 for controlling the load path. As shown in Figures 2, 3 and 4, the first load electrode 11 of a controllable semiconductor element T may be a first contact pad of the respective first semiconductor body 1, the second load electrode 12 of that controllable semiconductor element T may be a second contact pad of the respective first semiconductor body 1, and the control electrode 13 of that controllable semiconductor element T may be a third contact pad of the respective first semiconductor body 1. The first electrode 21 of the freewheeling element F may be a first contact pad of the second semiconductor body 2 and the second electrode 22 of the freewheeling element F may be a second contact pad of the second semiconductor body 2.

Depending on the type of controllable semiconductor element, the first load electrode 11 may be a source electrode or an emitter electrode, the second load electrode 12 may be a drain electrode or a collector electrode, and the control electrode 13 may be a gate electrode or a base electrode. In order to control such a controllable semiconductor element T, a control signal (e.g., voltage and/or current) may be applied between the first load electrode 11 and the control (third) electrode 13. The control voltage may be referenced to the electrical potential of the first load electrode 11.

The first contact pads of the first semiconductor bodies 1 may be disposed at a side of the first semiconductor body 10 of the corresponding first semiconductor body 1 facing away from the electrically insulated carrier 3. Accordingly, the second contact pads of the first semiconductor bodies 1 may be disposed at a side of the semiconductor layer 10 of the corresponding first semiconductor body 1 facing towards the electrically insulated carrier 3. Further, the third contact pads of the first semiconductor bodies 1 may be disposed at a side of the semiconductor layer 10 of the corresponding first semiconductor body 1 facing away from the electrically insulated carrier 3.

The first contact pad of the second semiconductor body 2 is disposed at a side of the semiconductor layer 20 facing away from the electrically insulated carrier 3, and the second electrode 22 of the second semiconductor body 2 may be disposed at a surface of the second semiconductor body 2 facing towards the electrically insulated carrier 3.

The first, second and third contact pads of the first semiconductor bodies 1 and the first and second contact pads of the second semiconductor body 2 may have been attached to the semiconductor layers 10, 20 of the corresponding semiconductor bodies 1, 2 before the corresponding semiconductor bodies 1, 2 were mounted onto the electrically insulated carrier 3.

The electrically insulated carrier 3 includes a dielectric insulation layer 300, a structured first metallization layer 310 attached to the dielectric insulation layer 300, and an optional second metallization layer 320 attached to the dielectric insulation layer 300. If there is a second metallization layer 320, the dielectric insulation layer 300 may be disposed between the first and second metallization layers 310, 320.

Each of the first and, if provided, second metallization layers 310, 320 may consist of or include, without being restricted to, one of the following materials: copper; a copper alloy; aluminum; an aluminum alloy; any other metal or alloy that remains solid during the operation of the semiconductor assembly. According to one example, the electrically insulated carrier 3 may be a ceramic substrate, that is, an electrically insulated carrier 3 in which the dielectric insulation layer 300 is a ceramic, e.g. a thin ceramic layer. The ceramic may, without being restricted to, consist of or include one of the following materials: aluminum oxide; aluminum nitride; zirconium oxide; silicon nitride; boron nitride; any other dielectric ceramic. For instance, the electrically insulated carrier 3 may, e.g., be a Direct Copper Bonding (DCB) substrate, a Direct Aluminum Bonding (DAB) substrate, or an Active Metal Brazing (AMB) substrate. According to another example, the electrically insulated carrier 3 may be a conventional printed circuit board (PCB) having a non-ceramic dielectric insulation layer 300. For instance, a non-ceramic dielectric insulation layer 300 may consist of or include a cured resin. Irrespective of the materials of the first and second metallization layers 310, 320 and the insulation layer 300, the electrically insulated carrier 3 may be free of electrical connections such as, e.g., vias (via = "vertical interconnect access") that pierce the insulation layer 300 and electrically interconnect the first and second metallization layers 310, 320.

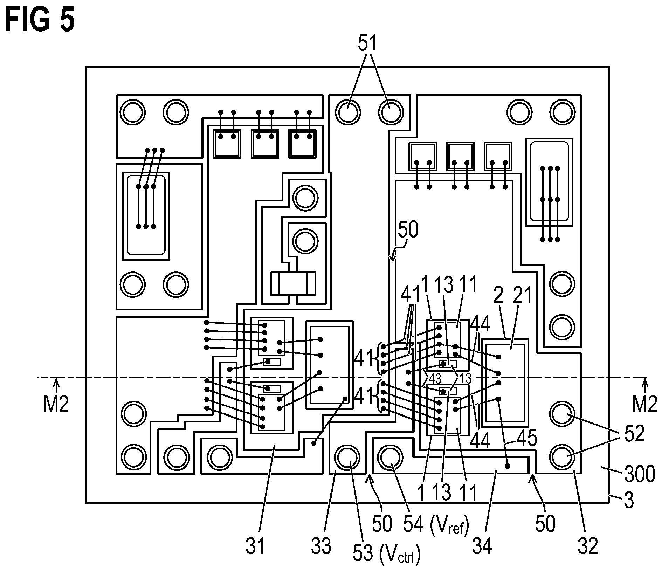

The electrically insulated carrier 3 may include a first conductor trace 31, a second conductor trace 32, a third conductor trace 33, and a fourth conductor trace 34 pairwise disposed distant from one another. That is, each of the conductor traces 31, 32, 33, 34 is disposed distant from each of the other of the conductor traces 31, 32, 33, 34. Generally, each of the conductor traces 31, 32, 33, 34 may be a conductor trace of the electrically insulated carrier 3. As illustrated in Figures 5 to 7, each of the conductor traces 31, 32, 33, 34 may be a section of the same metallization layer (here: the first metallization layer 310) of the electrically insulated carrier 3.

Optionally, each of the multiplicity of identical first semiconductor bodies 1 and the second semiconductor body 2 may be disposed on the second conductor trace 32. Thereby, each of the first semiconductor bodies 1 may be electrically and mechanically connected to the second conductor trace 32 by an electrically conductive first connection layer 61 (Figure 4) extending from the second conductor trace 32 to the second contact pad of the corresponding first semiconductor body 1, and/or the second semiconductor body 2 may be electrically and mechanically connected to the second conductor trace 32 by an electrically conductive second connection layer 62 (Figure 4) extending from the second conductor trace 32 to the second contact pad of the second semiconductor body. As shown in Figure 2, the design of the first metallization layer 310 may be such that it does not include a recess in the region(s) between the first semiconductor bodies 1 and the second semiconductor body 2. The absence of such a recess improves the heat spreading effect of the first metallization layer 310.

The type of the first connection layer 61 may be a solder layer, a layer of an electrically conductive adhesive, or a layer of a sintered metal powder, e.g. a sintered silver powder, or any other suitable layer. Independently from the type of the first connection layer 61, the type of the second connection layer 62 may be a solder layer, a layer of an electrically conductive adhesive, or a layer of a sintered metal powder, e.g. a sintered silver powder, or any other suitable layer. Optionally, the first and second connection layers 61, 62 may be sections of a common connection layer and be of the same type, for instance one of the types mentioned before.

In order to facilitate the electrical connection of the electrically insulated carrier 3 to a supply voltage, to an electrical load, or to a controller etc., the substrate arrangement may include electrical terminals 51, 52, 53, 54 which may be mounted on the electrically insulated carrier 3. For instance, one or more (here: two) first electrical terminals 51 may be mounted on and electrically connected to the first conductor trace 31, one or more (here: two) second electrical terminals 52 may be mounted on and electrically connected to the second conductor trace 32, one or more (here: one) third electrical terminal 53 may be mounted on and electrically connected to the third conductor trace 33, and one or more (here: one) fourth electrical terminals 54 may be mounted on and electrically connected to the fourth conductor trace 34. In the illustrated example, the terminals 51, 52, 53, 54 are metallic sleeves for receiving electrically conductive pins. However, any other type of terminals may be used as well. Instead of the first, second, third or fourth terminals 51, 52, 53, 54 mounted on and electrically connected to the first, second, third or fourth conductor traces 31, 32, 33, 34, the respective conductor traces 31, 32, 33, 34 themselves may form terminals. That is, separate terminals mounted on and electrically connected to the respective conductor traces may be omitted and the traces may serve as terminals.

As illustrated in Figure 1, the first electrodes 21₁ and 21₂ of the freewheeling element F is electrically connected to the first load electrode 11 of each of the multiplicity of controllable semiconductor elements T via an individual one of a multiplicity of first electrical lines 81. In Figure 1, one of the individual first electrical lines 81 is accentuated in a dotted fashion, another one in a dashed fashion.

Referring again to Figure 2, the first conductor trace 31 may serve to electrically interconnect the first load electrodes 11 (the first contact pads) of all first controllable semiconductor elements T integrated in the first semiconductor bodies 1, the second conductor trace 32 may serve to electrically interconnect the second load electrodes 12 (the second contact pad) of the multiplicity of controllable semiconductor elements T integrated in the first semiconductor bodies 1 and the second load electrode 22 (the second contact pad) of the freewheeling element F integrated in the second semiconductor body 2, and the control potential conductor trace 33 may serve to electrically interconnect the control electrodes 13 (the third contact pads) of the multiplicity of first controllable semiconductor elements T integrated in the first semiconductor bodies 1. Further, the first conductor trace 31 and the second conductor trace 32 may serve to carry a load current flowing through the electrically parallelized load paths of multiplicity of first semiconductor elements T integrated in the first semiconductor bodies 1, the third conductor trace 33 may serve to provide an electric control potential V_{ctrl} to the control electrodes 13 (the third contact pads), and the fourth conductor trace 34 may serve to provide an electric reference potential to the first load electrodes 11 (the first contact pads) of the first controllable semiconductor elements T.

As can be seen from Figure 1 in combination with Figures 2, 3 and 4, each of the individual first electrical lines 81 electrically connecting the first load electrode 11 (the first contact pad) of the respective first semiconductor body 1 with the first electrode 21 of the freewheeling element F may include at least one bonding wire 44 that is, at respective bonding locations, wire-bonded directly to both the respective first load electrode 11 (the respective first contact pad) and the first electrode 21 of the freewheeling element F. In Figures 2 to 8, the bonding locations at which a bonding wire is (wire) bonded to another element, are schematically illustrated by bold dots. A bonding wire is wire bonded at a bonding location to an electrically conductive element. The bonding wire directly contacts and forms a substance-to-substance-bond with the electrically conductive element at the bonding location so that the bonding wire and the electrically conductive element are electrically and mechanically connected at the bonding location. The provision of wire bonded connections, e.g. by ultrasonic wire bonding, is commonly known in the art so that no further explanation is required in this regard.

As can be seen from Figure 1 in combination with Figures 2, 3 and 4, each of the second electrical lines 82 electrically connecting the first load electrode 11 (the first contact pad) of the respective first semiconductor body 1 with the first terminal(s) 51 may include at least one bonding wire 41 that is, at respective bonding locations, wire-bonded directly to both the first load electrode 11 (the first contact pad) of the respective first semiconductor body 1 and the first conductor trace 31.

Each of the third electrical lines 83 electrically connecting the second load electrode 12 (the second contact pad) of the respective first semiconductor body 1 with the second terminal(s) 52 may include a first connection layer 61 that electrically and mechanically interconnects the respective second load electrode 12 (the respective second contact pad) and the second conductor trace 32.

Each of the fourth electrical lines 84 electrically connecting the control electrode 13 (the third contact pad) of the respective first semiconductor body 1 with the third terminal 53 may include a least one bonding wire 43 that is, at respective bonding locations, wire-bonded directly to both the respective control electrode 13 (the respective third contact pad) and the third conductor trace 33.

As described above, the first load electrode 11 of each of the multiplicity of first controllable semiconductor elements T integrated in the first semiconductor bodies 1 is electrically connected to the same first electrode 21 of the second semiconductor body 2 via an individual first electrical line 81. The individual first electrical lines 81 serve to apply an electric potential present at the first electrode 21 to the first load electrodes 11 (the first contact pads) of the first semiconductor bodies 1.

According to one option illustrated in Figures 1 and 2, each of the first electrical lines 81 may be connected such that a load current flowing (e.g. between the first load current conductor trace 31 and the second load current conductor trace 32) through the electrically parallelized load paths of the first controllable semiconductor elements T integrated in the first semiconductor bodies 1 or a partial current of such a load current does not flow through the first electrical lines 81 so that the load current or the partial current cannot cause an undesired voltage drop along the first electrical lines 81. That is, the electrical path for applying an electrical reference potential V_{ref}, which is supplied to the fourth conductor trace 34 and to the first load electrodes 11 of the first controllable semiconductor elements T (the first contact pads of the first semiconductor bodies 1) may be separated from an electrical path carrying the load current or a partial current of the load current.

Optionally, one, some or all electrical connections between the first load electrodes 11 of the first controllable semiconductor elements T (the first contact pads of the first semiconductor bodies 1) and the fourth conductor trace 34 may include no conductor trace of the electrically insulated carrier 3 or at least no conductor trace formed in the first metallization layer 310 so that a further structuration of a metallization layer of the electrically insulated carrier 3, in particular of the first metallization layer 310, to reduce the heat spreading effect of the respective metallization layer and, therefore, the heat spreading effect of the electrically insulated carrier 3, is not required.

As illustrated in Figure 1, first electrode 21 of the freewheeling element F (i.e. the first contact pad of the second semiconductor body 2) is, e.g. through an electrical line that may include one or more bonding wires 45, or through any other electrical connection, electrically connected to the fourth conductor trace 34. Thereby, the first electrode 21 of the freewheeling element F (the first contact pad of the second semiconductor body 2) may be a physical and electrical support point for each of the electrical connections between the first load electrode 11 of each of the multiplicity of controllable semiconductor elements T (the first contact pad of each of the first semiconductor bodies 1) and the fourth conductor trace 34 and/or between the first load electrode 11 of each of the multiplicity of controllable semiconductor elements T (the first contact pad of each of the first semiconductor bodies 1) and the fourth terminal 54. If the mentioned electrical line includes one or more bonding wires 45, each of these bonding wires 45 may be wire-bonded directly to both the first electrode 21 of the freewheeling element F (the first contact pad of the second semiconductor body 2) and the fourth conductor trace 34. As also shown in Figure 2, a bonding wire 44 and a bonding wire connection 45 may be electrically connected in series between the fourth conductor trace 34 and the first load electrode 11 of one of the multiplicity of controllable semiconductor elements T (the first contact pad of one of the first semiconductor bodies 1).

According to an option illustrated in Figure 2, an electrical connection between the first load electrode 11 of one of the first controllable semiconductor elements T (the first contact pad of one of the first semiconductor bodies 1) and the first electrode 21 of the freewheeling element F (the first contact pad of the second semiconductor body 2) and an electrical connection between the first electrode 21 of the freewheeling element F (the first contact pad of the second semiconductor body 2) and the fourth conductor trace 34 and/or the fourth terminal 53 may be realized using a single connecting element, e.g. a bonding wire. For instance, one of the first electrical lines 81 may be formed by a first section 44 of the bonding wire. Similarly, instead of providing a bonding wire 41 and a bonding wire 44 as separate bonding wires, there may be one bonding wire which is wire bonded to the first conductor trace 51, the first load electrode 11 of one of the first semiconductor bodies 1, and the first electrode 21 of the second semiconductor body 2. In Figure 5, such a bonding wire is schematically illustrated using a dashed line joining a bonding wire 41 and a bonding wire 44 to form a single bonding wire. More generally, any chain in which two or more of the described bonding wires are electrically connected in series may be replaced by a single bonding wire having sections so that each of the sections form a bonding wire connection that electrically connects the same elements as the corresponding replaced bonding wire.

As also illustrated in the example of Figure 5, a bonding wire 44 may be wire bonded to the first electrode 21 of the freewheeling element F (the first contact pad of the second semiconductor body 2) at only one bonding location. Alternatively (not shown), a bonding wire 44 could also be wire bonded to the first electrode 21 of the freewheeling element F (the first contact pad of the second semiconductor body 2) at at least two bonding locations.

As can be seen from the examples explained with reference to Figures 1 and 2 to 5, each first electrical line 81 physically and electrically contacts the first electrode 21 of the freewheeling element F integrated in the second semiconductor body 2 (the first contact pad of the second semiconductor body 2), whereas a second electrical line 82 may be distant from first electrode 21 (distant from the first contact pad of the second semiconductor body 2). That is, an electric reference potential V_{ref} applied to the fourth conductor trace 34 (e.g. directly or via the fourth terminal 54) is transferred to all first load electrodes 11 via the first electrode 21 of the same second semiconductor body 2 and the first electrical lines 81.

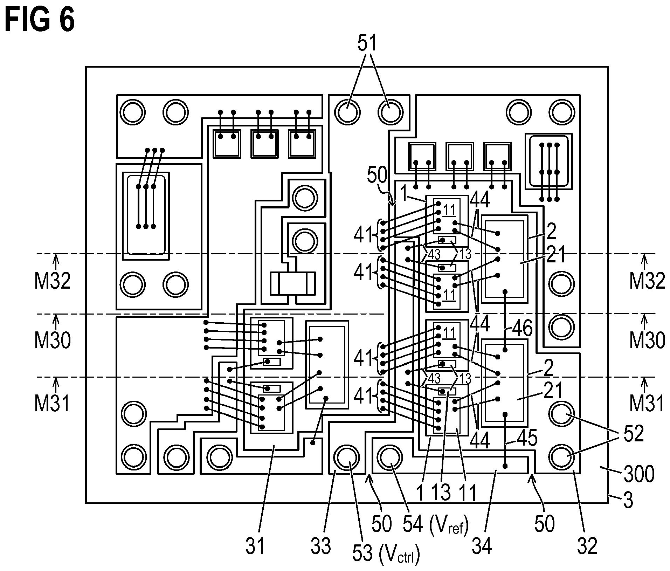

Even though the examples illustrated in Figures 5 and 6 show only two first semiconductor bodies 1, it is to be noted that the semiconductor arrangement may include more than two first semiconductor bodies 1 electrically connected in parallel. In this case, the first load electrodes 11 of more than two (even of each) of the first controllable semiconductor elements T integrated in the first semiconductor bodies 1 may be connected to the same first electrode 21 of the second semiconductor body 2 analogously.

Figure 6 illustrates a further example of a semiconductor arrangement. The semiconductor arrangement of Figure 6 is based on the semiconductor arrangement of Figure 2 with the difference, that the semiconductor arrangement of Figure 6 exemplarily includes more than two (here: four) first semiconductor bodies 1 (instead of two shown in Figure 2), and (at least) two second semiconductor bodies 2 (instead of one as in Figure 2). Each of the second semiconductor bodies 2 includes a freewheeling element F. The first electrodes 21 of these freewheeling elements F (the first contact pads of the second semiconductor bodies 2) are electrically interconnected, and the second electrodes 22 of these freewheeling elements F (the second contact pads of second semiconductor bodies 2) are electrically interconnected. Optionally, all second semiconductor bodies 2 may be identical. As shown in Figure 6, at least one first electrical line 81 may include and/or physically (and electrically) contact both the first electrode 21 of the freewheeling element F integrated in a first one of the second semiconductor bodies 2 (i.e. a first contact pad of a first one of the second semiconductor bodies 2) and the first electrode 21 of the freewheeling element F integrated in a second one of the second semiconductor bodies 2 (i.e. a first contact pad of a second one of the second semiconductor bodies 2).

The first load electrode 11 of each of at least one (here: of two) of the multiplicity of controllable semiconductor elements T is, e.g. through one or more bonding wires 44 or any other electrical connection, electrically connected to a first electrode 21 of the freewheeling element F integrated in a first one of the second semiconductor bodies 2 (the bottom one in Figure 6). Accordingly, the first load electrode 11 of each of at least one (here: of two) further of the multiplicity of controllable semiconductor elements T is, e.g. through one or more bonding wires 44 or any other electrical connection, electrically connected to the first electrode 21 of the freewheeling element F integrated in a second one of the second semiconductor bodies 2 (the top one in Figure 6). The first electrodes 21 of the controllable semiconductor elements F integrated in the second semiconductor bodies 2 (i.e. the first contact pads of the second semiconductor bodies 2) are interconnected, e.g. through an electrical connection which may include one or more bonding wires 46 or any other electrical connection. If the electrical connection includes one or more bonding wires 46, one, some or each of the bonding wires 46 may optionally be wire-bonded directly to the first electrodes 21 of the controllable semiconductor elements F integrated in both second semiconductor bodies 2 (i.e. to the first contact pads of both the first and second one of the second semiconductor bodies 2).

Further, an electrical connection may be formed between the first electrode 21 of the freewheeling element F integrated in one of the second semiconductor bodies 2 (i.e. the first contact pad of one of the second semiconductor bodies 2) and the fourth conductor trace 34. If the electrical connection includes at least one bonding wire 45, one, more than one or each of the bonding wires 45 may be wire-bonded directly to both the respective first electrode 21 (the respective first contact pad) and the fourth conductor trace 34.

As can be seen from Figure 6, the first load electrode 11 of each of the first semiconductor bodies 1 is electrically connected via a first electrical line 81 (see Figure 1) to the first electrode of the same second semiconductor body 2 (the bottom one in Figure 6). The first electrical lines 81 serve to apply a reference potential V_{ref} to the fourth conductor trace 34 and/or to the fourth terminal 54 and relative to which the control voltage V_{ctrl} - V_{ref} is determined, to the first load electrodes 11 of each of the multiplicity of the controllable semiconductor elements T. For instance, such a control voltage V_{ctrl} -V_{ref} may be provided by a control voltage source located on or externally to the electrically insulated carrier 3. In order to prevent differences between the control voltages that occur directly at the places of the individual first semiconductor bodies 1, all first electrical lines 81 may be configured to provide identical voltage and current transfers. Separate electrical lines are configured to provide an identical voltage and current transfer if, for each signal that is transferred via each of the separate electrical lines, the separate electrical lines transfer (if there is a distortion: distort) the signal in the same manner. As a result, the (transferred) signals are identical at any time. This means, with regard to the first electrical lines 81, that the voltages between the control electrodes 13 and the first load electrodes 11 of the individually controllable semiconductor elements T integrated in the individual first semiconductor bodies 1 are identical at any time, and that the currents through the separate first electrical lines 81 are identical or substantially identical at any time. That is, the time-dependent behavior of the voltages between the control electrodes 13 and the first load electrodes 11 are identical and synchronous for all controllable semiconductor elements T, so that the states of operation of all controllable semiconductor elements T are, at any time, identical.

In order to achieve separate electrical lines configured to provide an identical voltage and current transfer, the separate electrical lines may be designed to have at least one of: identical ohmic behaviors, identical inductive behaviors and identical capacitive behaviors. Generally, an electrical line may consist of or include one or more of the following electrically conductive elements: a wire (e.g. a bonding wire), a single metal sheet, a metal bar, a conductor trace of an electrically insulated carrier, a solder layer, a layer of sintered metal powder, an electrically conductive adhesive, or it may consist of or include any combination with two or more of the mentioned elements. In case of the two or more electrically conductive elements, the elements may be electrically connected in parallel and/or in series. In the illustrated examples, one or more bonding wires (e.g. bonding wires) and conductor tracks of an electrically insulated carrier 3 are used. The design of the mentioned elements can be adapted to achieve desired electrical properties like identical ohmic behaviors, identical inductive behaviors and identical capacitive behaviors.

For instance, two electrically conductive elements may be designed to provide an identical voltage and current transfer if they are identical (e.g. have, inter alia, identical shapes, identical lengths, identical cross-sectional areas, identical materials or material compositions, etc.) and/or have a geometrically symmetrical design (e.g. mirror-symmetrical, point-symmetrical, rotational-symmetrical, etc.) relative to one another. However, also non-identical and/or non-symmetrical electrically conductive elements may be designed to have at least one of: identical ohmic behaviors, identical inductive behaviors; identical capacitive behaviors. For instance, a desired ohmic resistance of an electrically conductive element may be adjusted by appropriately selecting its cross-section, its length, the electrical resistivity of the material used for the elements, etc. A desired inductivity of an electrically conductive element may be adjusted by appropriately selecting e.g. the shape and the length of the element. For instance, the inductivity of a straight wire may be increased if the wire is distorted, e.g. curved or wound to a coil. Desired capacitive properties of an electrically conductive element may be adjusted by appropriately selecting e.g. its shape, its length and its course. Because the ohmic resistance, the inductivity and the capacitive properties of a single electrically conductive element can be adjusted as described, the ohmic behavior, the inductive behavior and the capacitive behavior of a conductive line consisting of a single electrically conductive element or of a combination of at least two electrically interconnected electrically conductive elements can be adjusted as well.

According to examples illustrated in Figures 2 and 5, 7 and 8, the individual first electrical lines 81 (see Figure 1), each formed by, without being restricted to, one bonding wire or more bonding wires 44 electrically connected in parallel between the same first electrode 21 of the freewheeling element F integrated in the second semiconductor body 2 (i.e. the same first contact pad of the second semiconductor body 2) and the first load electrode 11 of each of the first individual controllable semiconductor elements T integrated in the first semiconductor bodies 1 (i.e. the first contact pad of each of the first semiconductor bodies 1) may be identical, and/or geometrically symmetrical (e.g. mirror-symmetrical and/or rotational-symmetrical) to one another. Figure 2 shows two first electrical lines 81 each consisting of two bonding wires 44. The two first electrical lines 81 are mirror-symmetric to one another relative to a mirror-plane M1-M1. Figure 5 also shows two first electrical lines 81 each consisting of two bonding wires 44. The first two electrical lines 81 are mirror-symmetric to one another relative to a mirror-plane M2-M2. Figure 6 shows four first electrical lines 81 each consisting of two bonding wires 44. The two bottom-most first electrical lines 81 are mirror-symmetric to one another relative to a mirror-plane M31-M31, the two top-most first electrical lines 81 are mirror-symmetric to one another relative to a mirror-plane M32-M32, and the group consisting of the two bottom-most first electrical lines 81 is mirror-symmetric to the group consisting of the two top-most first electrical lines 81 relative to a mirror-plane M30-M30. Figure 7 shows two first electrical lines 81 each consisting of two bonding wires 44. The two first electrical lines 81 are mirror-symmetric to one another relative to a mirror-plane M4-M4. Figure 8 shows four first electrical lines 81 each consisting of a single bonding wire 44. The two top-most first electrical lines 81 are mirror-symmetric to the two bottom-most first electrical lines 81 relative to a mirror-plane M5-M5, and the two left-most first electrical lines 81 are mirror-symmetric to the two right-most first electrical lines 81 relative to a mirror-plane S5-S5.

Optionally, the second electrical lines 82 (see Figure 1) electrically connecting the first terminal(s) 51 and/or the first conductor trace 31 to the first load electrodes 11 of the multiplicity of controllable semiconductor elements T may also be configured to provide an identical voltage and current transfer. When regarding the first conductor trace 31 as "first terminal", each of the second lines 82 in Figures 2 and 5 to 11 is formed by, without being restricted to, one bonding wire 41 or more bonding wires 41 electrically connected in parallel between the first load electrode 11 of the respective first controllable semiconductor element T and the first conductor trace 31. The second lines 82 may be identical, and/or symmetrical (e.g. mirror-symmetrical and/or rotational-symmetrical) to one another. Figure 2 shows two second electrical lines 82 each consisting of four bonding wires 41. The two second electrical lines 82 are mirror-symmetric to one another relative to the mirror-plane M1-M1. Figure 5 also shows two second electrical lines 82 each consisting of four bonding wires 41. The two second electrical lines 82 are mirror-symmetric to one another relative to a mirror-plane M2-M2. Figure 6 shows four second electrical lines 82 each consisting of four bonding wires 44. The two bottom-most second electrical lines 82 are mirror-symmetric to one another relative to the mirror-plane M31-M31, the two top-most second electrical lines 82 are mirror-symmetric to one another relative to the mirror-plane M32-M32, and the group consisting of the two bottom-most second electrical lines 82 is mirror-symmetric to the group consisting of the two bottom-most second electrical lines 82 relative to the mirror-plane M30-M30. Figure 7 shows two second electrical lines 82 each consisting of four bonding wires 41. The two second electrical lines 82 are mirror-symmetric to one another relative to a mirror-plane M4-M4. Figure 8 shows four second electrical lines 82 each consisting of a single bonding wire 41. The two top-most second electrical lines 82 are mirror-symmetric to the two bottom-most second electrical lines 82 relative to the mirror-plane M5-M5, and the two left-most second electrical lines 82 are mirror-symmetric to the two right-most second electrical lines 82 relative to the mirror-plane S5-S5.

Also optionally, the third electrical lines 83 (see Figure 1) electrically connecting the second terminal(s) 52 and/or the second conductor trace 32 to the second load electrodes 12 of the multiplicity of controllable semiconductor elements T may be configured to provide an identical voltage and current transfer. As can be seen by comparing Figures 2 and 5, each of the second electrical lines 82 may include a section of the second conductor trace 32 and the electrically conductive first connection layer 61.

Also optionally, the fourth electrical lines 84 (see Figure 1) electrically connecting the third terminal 53 and/or the third conductor trace 33 to the control electrodes 13 of the multiplicity of controllable semiconductor elements T may also be configured to provide an identical voltage and current transfer. When regarding the third conductor trace 33 as "third terminal", each of the fourth lines 84 in Figures 2, 3 and 5 to 11 is formed by, without being restricted to, one bonding wire 43 or more bonding wires 43 electrically connected between the control electrode 13 of the respective first controllable semiconductor element T and the third conductor trace 33. The fourth lines 84 may be identical, and/or symmetrical (e.g. mirror-symmetrical and/or rotational-symmetrical) to one another. Figure 2 shows two fourth electrical lines 84 each consisting of one bonding wire 43 (see also Figure 3). The two fourth electrical lines 84 are mirror-symmetric to one another relative to the mirror-plane M1-M1. Figure 5 also shows two fourth electrical lines 84 each consisting of one bonding wire 43. The two fourth electrical lines 84 are mirror-symmetric to one another relative to a mirror-plane M2-M2. Figure 6 shows four fourth electrical lines 84 each consisting of one bonding wire 43. The two bottom-most fourth electrical lines 84 are mirror-symmetric to one another relative to the mirror-plane M31-M31, the two top-most fourth electrical lines 84 are mirror-symmetric to one another relative to the mirror-plane M32-M32, and the group consisting of the two bottom-most fourth electrical lines 84 is mirror-symmetric to the group consisting of the two bottom-most fourth electrical lines 84 relative to the mirror-plane M30-M30. Figure 7 shows two fourth electrical lines 84 each consisting of one bonding wire 43. The two fourth electrical lines 84 are mirror-symmetric to one another relative to the mirror-plane M4-M4. Figure 8 shows four fourth electrical lines 84 each consisting of a single bonding wire 43. The two top-most fourth electrical lines 84 are mirror-symmetric to the two bottom-most fourth electrical lines 84 relative to the mirror-plane M5-M5, and the two left-most fourth electrical lines 84 are mirror-symmetric to the two right-most fourth electrical lines 84 relative to the mirror-plane S5-S5.

As exemplarily illustrated in Figures 2 to 7, forming first, second, third and fourth conductor traces 31, 32, 33, 34 in the first metallization layer 310 may require the formation of recesses 50 between adjacent conductor traces 31, 32, 33, 34. Such recesses 50, however, reduce the heat spreading effect of the first metallization layer 310. Therefore, using a design in which each of the electrical connections between the first load electrodes 11 and the fourth conductor traces 34 and/or between the first load electrodes 11 and the fourth terminal 54 is electrically and physically led via the first electrode 21 of at least one second semiconductor body 2, allows for reducing the number and/or length of conductor traces accompanied by unnecessary recesses 50 in the first metallization layer 310 so that the heat spreading effect of the first metallization layer 310 and, therefore, the heat spreading effect of the electrically insulated carrier 3 is increased.

Optionally, each of the controllable semiconductor elements T included in the first semiconductor bodies 1 may include an integrated, e.g. intrinsic, freewheeling element 14 (see Figure 1) electrically connected between the first load electrode 11 and the second load electrode 12 of the corresponding controllable semiconductor element T. If the controllable semiconductor elements T are RC-MOSFETs or RC-IGBTs (RC = reverse conducting), the integrated freewheeling elements 14 may be body diodes of the respective controllable semiconductor element T. If the load paths of the controllable semiconductor elements T can (via the corresponding control electrode 13) be controlled and a reverse current can flow between the first and second load electrodes 11, 12 through the load path, the controllable semiconductor element T has a controllable reverse conductivity. Suitable controllable semiconductor elements T having a controllable reverse conductivity are, e.g., JFETs or HEMTs.

Even though the controllable semiconductor elements T included in the first semiconductor bodies 1 may have an internal, e.g. intrinsic, freewheeling element 14 that can be used for a freewheeling operation, one or more second semiconductor bodies 2 each including a freewheeling element F may be provided as described so that the freewheeling operation can make use of both the freewheeling operation of intrinsic or controllable reverse conductivities of the controllable semiconductor elements T included in the first semiconductor bodies 1 and a freewheeling element F included in a second semiconductor body 2. One advantage of such a design is that the arrangement's electrical losses occurring during the freewheeling operation can at least partly be shifted from the first semiconductor bodies 1 to the freewheeling element(s) F integrated in the second semiconductor body(s) 2. If (e.g. SiC-based) controllable semiconductor elements T are employed, e.g. in a power factor correction (PFC) unit and/or in a boost converter, the freewheeling element F (e.g. a Si-diode) integrated in a second semiconductor body 2 serves to protect the freewheeling elements 14 integrated in the first semiconductor bodies 1, when the controllable semiconductor element T integrated in the first semiconductor body 1 is operated in a reverse operation without controlled commutation, against an overload of the freewheeling elements 14 integrated in the first semiconductor bodies 1.

For instance, intrinsic reverse conductivities of controllable semiconductor elements T, in particular of unipolar controllable semiconductor elements T and/or of controllable semiconductor elements T having an internal body diode, are comparatively low as compared to the forward conductivities of available low-loss diodes (e.g. a low-loss diode having a rectifying pn- or Schottky junction 212 with a low forward voltage, e.g., a silicon (Si)-based diode having a Si-based semiconductor body 20) that may be integrated in a second semiconductor body 2 as a freewheeling element F. Further, the complexity of a controller required for controlling the first semiconductor bodies 1 may be reduced because there is no sophisticated controlled freewheeling operation of the first semiconductor bodies 1 required.

If the reverse conductivities of the controllable semiconductor elements T are caused by body diodes of the controllable semiconductor elements T, the losses that occur during the free-wheeling operation in the body diodes are substantially determined by the forward voltages of the body diodes. Therefore, using a diode as the freewheeling element F having a first forward voltage lower than a second forward voltage of the body diode(s) of the controllable semiconductor elements T may significantly reduce the losses that occur during the operation of the semiconductor arrangement.

As explained above, at least one (optionally: each) of the at least one second semiconductor bodies 2 includes a freewheeling (flyback) element F. A freewheeling element F is in a blocking state or can be switched into a blocking state (in a blocking state, an electrical path between the first electrode 21 and the second electrode 22 is blocking) when a voltage, which allows for an operation of the first semiconductor bodies 1 in the forward direction of the first semiconductor bodies 1, is applied between the first load electrodes 11 and second load electrodes 12 (and, therefore, between the first electrode 21 and the second electrode 22). Further, a freewheeling element F is in a conductive state or can be switched into a conductive state (in a conductive state, an electrical path between the first electrode 21 and the second electrode 22 is conductive) when a reverse voltage is applied between the first load electrodes 11 and second load electrodes 12 (and, therefore, between the first electrode 21 and the second electrode 22).

As illustrated in Figure 4, a second semiconductor body 20 which includes a freewheeling element F may include a rectifying junction 212. According to the example illustrated in connection with Figure 4, such a rectifying junction 212 may be a pn-junction formed between a first semiconductor region 201 of the second semiconductor body 20 and a second semiconductor region 202 of the second semiconductor body 20. The first semiconductor region 201 has a first conduction type (here: p), and the second semiconductor region 202 may have a second conduction type (here: n) complementary to the first conduction type. The first conduction type is, as illustrated in Figure 4, 'p' and the second conduction type is 'n' if the forward operation of the controllable semiconductor elements T integrated in the first semiconductor bodies 1 requires an electrical potential of the second load electrode(s) 12 to be positive relative to an electrical potential of the first load electrode(s) 11. Conversely, if the forward operation of the controllable semiconductor elements T integrated in the first semiconductor bodies 1 requires an electrical potential of the second load electrode(s) 12 to be negative relative to an electrical potential of the first load electrode(s) 11, the first conduction type is 'n' and the second conduction type is 'p'.

Alternative to a pn-junction, a rectifying junction 212 may be a Schottky-junction. If the forward operation of the controllable semiconductor elements T integrated in the first semiconductor bodies 1 requires an electrical potential of the second load electrodes 12 to be positive relative to an electrical potential of the first load electrodes 11, the second semiconductor body 20 may include an n-doped semiconductor region which adjoins the first electrode 21 forming a rectifying Schottky-junction, and which adjoins the second electrode 22 forming an ohmic contact. Conversely, if the forward operation of the controllable semiconductor elements T integrated in the first semiconductor bodies 1 requires an electrical potential of the second load electrodes 12 to be negative relative to an electrical potential of the first load electrodes 11, the second semiconductor body 20 may include an n-doped semiconductor region which adjoins the second electrode 22 forming a rectifying Schottky-junction, and which adjoins the first electrode 21 forming an ohmic contact.

As explained above, a freewheeling element F may be a diode, e.g. a pn-diode or a Schottky-diode, integrated in a second semiconductor body 20 and electrically connected between the first electrode 21 and the second electrode 22 of the respective second semiconductor body 2. Alternatively to a diode, the freewheeling element F integrated in a second semiconductor body 2 explained with reference to the previous figures may be a controllable semiconductor element. Such a controllable freewheeling semiconductor element F may be operated such that it is in a blocking state or is switched into a blocking state when a voltage, which allows for an operation of the parallelized first semiconductor bodies 1 in the forward direction of the first semiconductor bodies 1, is applied between the first load electrodes 11 and second load electrodes 12 (and, therefore, between the first electrode 21 and the second electrode 22), and which is in a conductive state or is switched into a conductive state when a reverse voltage is applied between the first load electrodes 11 and the second load electrodes 12 (and, therefore, between the first electrode 21 and the second electrode 22). For instance, a freewheeling element F formed as a controllable semiconductor element may be, without being restricted to, an IGFET (Insulated Gate Field Effect Transistor) like a MOSFET (Metal Oxide Semiconductor Field-Effect Transistor) or an IGBT (Insulated Gate Bipolar Transistor; e.g. a reverse conducting IGBT), a JFET, a HEMT, or any other suitable controllable semiconductor element.

An example of a semiconductor arrangement in which a second semiconductor body 2 includes a controllable freewheeling element F is illustrated in Figure 7. In addition to the first electrode 21 and the second electrode 22 explained with reference to Figures 1 to 6, the second semiconductor body 2 includes a control electrode 23 for controlling a load path of the controllable freewheeling element F formed between the first electrode 21 and the second electrode 22. The control electrode 23 may be connected to a control input (e.g. a gate or a base) of the controllable freewheeling element. There is no electrical connection between the control electrode 23 of such a freewheeling element F integrated in a second semiconductor body 2 and the control electrodes 13 of the controllable semiconductor elements T integrated in the first semiconductor bodies 1 so that a first control potential can be provided by a first control circuit to the control electrodes 13, and a second control potential having a signal course significantly different from the signal course of the first control potential can be provided by a second control circuit to the control electrode(s) 23 of one or more second semiconductor bodies 2.

Alternatively or additionally to an operation as a freewheeling element F, such a controllable semiconductor switch integrated in a second semiconductor body 2 may be operated such that its load path formed between the first and second electrodes 21 and 22 is blocking during a normal operation of the controllable semiconductor elements T integrated in the first semiconductor bodies 1, and that its load path is switched to a fully or at least partly conductive state in response to a detected overload of at least one of the controllable semiconductor elements T integrated in the first semiconductor bodies 1. For instance, the detected overload may be a detected excess voltage across the first and second load electrodes 11, 12 of a first semiconductor body 1, and/or a detected excess temperature of a first semiconductor body 1.

The following table shows examples of combinations of controllable semiconductor elements T and freewheeling element(s) F. However, it should be pointed out that the disclosure is not restricted to the mentioned combinations.

| Controllable semiconductor elements T | | Freewheeling element(s) F | |
|---|---|---|---|
| first semiconductor bodies 10 | type | second semiconductor body/bodies 20 | type |
| SiC-based | MOSFET or IGBT or RC-IGBT | Si-based | pn-junction diode |
| Si-based | MOSFET or IGBT or RC-IGBT | Si-based | pn-junction diode |
| SiC-based | MOSFET or IGBT or RC-IGBT | non-Si-based | pn-junction diode |
| Si-based | MOSFET or IGBT or RC-IGBT | non-Si-based | pn-junction diode |
| SiC-based | MOSFET or IGBT or RC-IGBT | any | Schottky-diode |
| Si-based | MOSFET or IGBT or RC-IGBT | any | Schottky-diode |
| GaN-based | HEMT | Si-based | pn-junction diode |
| GaN-based | HEMT | non-Si-based | pn-junction diode |
| GaN-based | HEMT | any | Schottky-diode |

Optionally, as illustrated in Figure 7, the electrically insulated carrier 3 may include a fifth conductor trace 35 which is disposed distant from each of the first, second, third and fourth conductor traces 31, 32, 33, 34 and which serves to supply a further electrical control potential V_{ctrl2} applied to it to the control electrode(s) 23 of the controllable freewheeling elements F integrated in the second semiconductor body(s) 2, e.g. via an electrical connection like a bonding wire 47 or the like. If desired, a fifth electrical terminal 55 may be mounted on the electrically insulated carrier 3, e.g. on the fifth conductor trace 35, and electrically connected to it in order to facilitate applying the further electrical control potential V_{ctrl2} to the fifth conductor trace 35.

## Claims

1. A semiconductor arrangement comprising:
a multiplicity of identical controllable semiconductor elements (T), each comprising a first load electrode (11), a second load electrode (12) and a control electrode (13);
a freewheeling element (F) comprising a first electrode (21) and a second electrode (22);
a first terminal (51) electrically connected to the first load electrodes (11) of the multiplicity of controllable semiconductor elements (T);
a second terminal (52) electrically connected to the second load electrodes (12) of the multiplicity of controllable semiconductor elements (T) and to the second electrode (22) of the freewheeling element (F);
a third terminal (53) electrically connected to the control electrodes (13) of the multiplicity of controllable semiconductor elements (T); and
a fourth terminal (54) electrically connected to the first electrode (21) of the freewheeling element (F); wherein
the first electrode (21) of the freewheeling element (F) is electrically connected to the first load electrode (11) of each of the multiplicity of controllable semiconductor elements (T) via an individual one of a multiplicity of separate first lines (81),
the fourth terminal (54) serves to provide in use an electric reference potential (V_{ref}), and
the fourth terminal (54) is electrically connected to all first load electrodes (11) solely via the first electrode (21) of the freewheeling element (F) and the respective separate first lines (81).

2. The semiconductor arrangement of claim 1, wherein the individual first lines (81) are configured to provide identical voltage and current transfers.

3. The semiconductor arrangement of claim 2, wherein the individual first lines (81) exhibit at least one of identical ohmic behaviors, identical inductive behaviors, and identical capacitive behaviors.

4. The semiconductor arrangement of claim 3, wherein the individual first lines (81) are wires of identical lengths, identical cross sectional areas, and identical materials.

5. The semiconductor arrangement of any of claims 1 to 4, further comprising:
a multiplicity of first semiconductor bodies (1), each including an individual one of the multiplicity of controllable semiconductor elements (T); and
a second semiconductor body (2) including the freewheeling element (F).

6. The semiconductor arrangement of claim 5, further comprising an electrically isolated carrier with a structured metallization, wherein the first semiconductor bodies (1) and the second semiconductor body (2) are disposed on and attached to the metallization of the carrier (3).

7. The semiconductor arrangement of claim 6, wherein each of the first semiconductor bodies (1) comprises:
a first contact pad electrically connected to the first electrode (21) of the corresponding controllable semiconductor element (T) disposed on a surface of the respective first semiconductor body (1) facing away from the carrier (3); and
a second contact pad that is electrically connected to at least a part of the structured metallization of the carrier (3) and to the second electrode of the corresponding controllable semiconductor element (T).

8. The semiconductor arrangement of claim 6 or 7, wherein the second semiconductor body (2) comprises:
a first contact pad electrically connected to the first electrode (21) of the freewheeling element (F) and disposed at a side of the first semiconductor body (2) facing away from the carrier (3); and
a second contact pad electrically connected to at least a part of the structured metallization of the carrier (3) and to the second electrode of the freewheeling element (F).

9. The semiconductor arrangement of claim 8, wherein the first contact pad of the second semiconductor body is electrically connected to the first contact pads of the first semiconductor bodies via separate wires.

10. The semiconductor arrangement of claim 8 or 9, wherein the second contact pad of the second semiconductor body is electrically connected to the second contact pads of the first semiconductor bodies via at least parts of the metallization of the carrier (3).

11. The semiconductor arrangement of any of claims 1 to 10 wherein:
each of the controllable semiconductor elements (T) includes an intrinsic freewheeling element (14) electrically connected between the first load electrode (11) and the second load electrode (12) of the controllable semiconductor element (T).

12. The semiconductor arrangement of claim 11 wherein the intrinsic freewheeling element (14) of each of the multiplicity of controllable semiconductor elements (T) is a body diode of the corresponding controllable semiconductor element (T).

13. The semiconductor arrangement of claim 11 or 12 wherein:
the freewheeling element (F) comprises a diode with a first forward voltage;
each of the body diodes of the controllable semiconductor elements (T) comprises a second forward voltage; and
the second forward voltage is greater than the first forward voltage.

14. The semiconductor arrangement of any of claims 1 to 13, wherein the fourth terminal is electrically connected to the first electrode (21) of the freewheeling element (F) via a separate third line.

15. The semiconductor arrangement of any of claims 1 to 14 wherein each of the multiplicity of controllable semiconductor elements (T) is a metal oxide semiconductor field effect transistor or a bipolar transistor or an insulated gate bipolar transistor.

## Patentansprüche

1. Halbleiteranordnung, die Folgendes umfasst:
eine Mehrzahl identischer steuerbarer Halbleiterelemente (T), die jeweils eine erste Lastelektrode (11), eine zweite Lastelektrode (12) und eine Steuerelektrode (13) umfassen;
ein Freilaufelement (F), das eine erste Elektrode (21) und eine zweite Elektrode (22) umfasst;
einen ersten Anschluss (51), der elektrisch mit den ersten Lastelektroden (11) der Mehrzahl steuerbarer Halbleiterelemente (T) verbunden ist;
einen zweiten Anschluss (52), der elektrisch mit den zweiten Lastelektroden (12) der Mehrzahl steuerbarer Halbleiterelemente (T) und der zweiten Elektrode (22) des Freilaufelements (F) verbunden ist;
einen dritten Anschluss (53), der elektrisch mit den Steuerelektroden (13) der Mehrzahl steuerbarer Halbleiterelemente (T) verbunden ist; und
einen vierten Anschluss (54), der elektrisch mit der ersten Elektrode (21) des Freilaufelements (F) verbunden ist; wobei
die erste Elektrode (21) des Freilaufelements (F) über eine einzelne einer Mehrzahl getrennter erster Leitungen (81) elektrisch mit der ersten Lastelektrode (11) jedes der Mehrzahl steuerbarer Halbleiterelemente (T) verbunden ist,
der vierte Anschluss (54) dazu dient, im Gebrauch ein elektrisches Referenzpotenzial (V_{ref}) bereitzustellen, und
der vierte Anschluss (54) alleinig über die erste Elektrode (21) des Freilaufelements (F) und die jeweiligen getrennten ersten Leitungen (81) elektrisch mit allen ersten Lastelektroden (11) verbunden ist.

2. Halbleiteranordnung nach Anspruch 1, wobei die einzelnen ersten Leitungen (81) dazu ausgelegt sind, identische Spannungs- und Stromübertragungen bereitzustellen.

3. Halbleiteranordnung nach Anspruch 2, wobei die einzelnen ersten Leitungen (81) identische ohmsche Verhalten und/oder identische induktive Verhalten und/oder identische kapazitive Verhalten zeigen.

4. Halbleiteranordnung nach Anspruch 3, wobei die einzelnen ersten Leitungen (81) Drähte mit identischer Länge, identischen Querschnittsflächen und identischen Materialien sind.

5. Halbleiteranordnung nach einem der Ansprüche 1 bis 4, die ferner Folgendes umfasst:
eine Mehrzahl erster Halbleiterkörper (1), die jeweils ein einzelnes der Mehrzahl steuerbarer Halbleiterelemente (T) beinhalten; und
einen zweiten Halbleiterkörper (2), der das Freilaufelement (F) beinhaltet.

6. Halbleiteranordnung nach Anspruch 5, die ferner einen elektrisch isolierten Träger mit einer strukturierten Metallisierung umfasst, wobei die ersten Halbleiterkörper (1) und der zweite Halbleiterkörper (2) auf der Metallisierung des Trägers (3) angeordnet und an diesem angebracht sind.

7. Halbleiteranordnung nach Anspruch 6, wobei jeder der ersten Halbleiterkörper (1) Folgendes umfasst:
ein erstes Kontaktpad, das elektrisch mit der ersten Elektrode (21) des entsprechenden steuerbaren Halbleiterelements (T) verbunden ist, auf einer Oberfläche des jeweiligen ersten Halbleiterkörpers (1) vom Träger (3) weg zeigend angeordnet; und
ein zweites Kontaktpad, das elektrisch mit zumindest einem Teil der strukturierten Metallisierung des Trägers (3) und der zweiten Elektrode des entsprechenden steuerbaren Halbleiterelements (T) verbunden ist.

8. Halbleiteranordnung nach Anspruch 6 oder 7, wobei der zweite Halbleiterkörper (2) Folgendes umfasst:
ein erstes Kontaktpad, das elektrisch mit der ersten Elektrode (21) des Freilaufelements (F) verbunden und an einer Seite des ersten Halbleiterkörpers (2) von dem Träger (3) weg zeigend angeordnet ist; und
ein zweites Kontaktpad, das elektrisch mit zumindest einem Teil der strukturierten Metallisierung des Trägers (3) und der zweiten Elektrode des Freilaufelements (F) verbunden ist.

9. Halbleiteranordnung nach Anspruch 8, wobei das erste Kontaktpad des zweiten Halbleiterkörpers über getrennte Drähte elektrisch mit den ersten Kontaktpads der ersten Halbleiterkörper verbunden ist.

10. Halbleiteranordnung nach Anspruch 8 oder 9, wobei das zweite Kontaktpad des zweiten Halbleiterkörpers über zumindest Teile der Metallisierung des Trägers (3) elektrisch mit den zweiten Kontaktpads der ersten Halbleiterkörper verbunden ist.

11. Halbleiteranordnung nach einem der Ansprüche 1 bis 10, wobei:
jedes der steuerbaren Halbleiterelemente (T) ein intrinsisches Freilaufelement (14) beinhaltet, das elektrisch zwischen der ersten Lastelektrode (11) und der zweiten Lastelektrode (12) des steuerbaren Halbleiterelements (T) geschaltet ist.

12. Halbleiteranordnung nach Anspruch 11, wobei das intrinsische Freilaufelement (14) jedes der Mehrzahl steuerbarer Halbleiterelemente (T) eine Körperdiode des entsprechenden steuerbaren Halbleiterelements (T) ist.

13. Halbleiteranordnung nach Anspruch 11 oder 12, wobei:
das Freilaufelement (F) eine Diode mit einer ersten Durchlassspannung umfasst;
jede der Körperdioden der steuerbaren Halbleiterelemente (T) eine zweite Durchlassspannung umfasst; und
die zweite Durchlassspannung größer als die erste Durchlassspannung ist.

14. Halbleiteranordnung nach einem der Ansprüche 1 bis 13, wobei der vierte Anschluss über eine getrennte dritte Leitung elektrisch mit der ersten Elektrode (21) des Freilaufelements (F) verbunden ist.

15. Halbleiteranordnung nach einem der Ansprüche 1 bis 14, wobei jedes der Mehrzahl steuerbarer Halbleiterelemente (T) ein Metalloxidhalbleiter-Feldeffekttransistor oder ein Bipolartransistor oder ein Bipolartransistor mit isoliertem Gate ist.

## Revendications

1. Agencement de semi-conducteurs, comprenant :
une multiplicité d'éléments (T) semi-conducteurs identiques commandables, chacun comprenant une première électrode (11) de charge, une deuxième électrode (12) de charge et une électrode (13) de commande ;
un élément (F) de roue libre, comprenant une première électrode (21) et une deuxième électrode (22) ;
une première borne (51) connectée électriquement aux premières électrodes (11) de charge de la multiplicité d'éléments (T) semi-conducteurs commandables ;
une deuxième borne (52) connectée électriquement aux deuxièmes électrodes (12) de charge de la multiplicité d'éléments (T) semi-conducteurs commandables et à la deuxième électrode (22) de l'élément (F) de roue libre ;
une troisième borne (53) connectée électriquement aux électrodes (13) de commande de la multiplicité d'éléments (T) semi-conducteurs commandables ; et
une quatrième borne (54) connectée électriquement à la première électrode (21) de l'élément (F) de roue libre ; dans lequel
la première électrode (21) de l'élément (F) de roue libre est connectée électriquement à la première électrode (11) de charge de chacun de la multiplicité d'éléments (T) semi-conducteurs commandables par l'intermédiaire individuellement d'une multiplicité de premières lignes (81) distinctes,
la quatrième borne (54) sert à donner en utilisation un potentiel (V_{ref}) de référence électrique, et
la quatrième borne (54) est connectée électriquement à toutes les premières électrodes (11) de charge seulement par l'intermédiaire de la première électrode (21) de l'élément (F) de roue libre et les premières lignes (81) distinctes respectives.

2. Agencement de semi-conducteurs suivant la revendication 1, dans lequel les premières lignes (81) individuelles sont configurées pour donner des transferts identiques de tension et de courant.

3. Agencement de semi-conducteurs suivant la revendication 2, dans lequel les premières lignes (81) individuelles présentent au moins les uns de comportements ohmiques identiques, de comportements inductifs identiques et de comportements capacitifs identiques.

4. Agencement de semi-conducteurs suivant la revendication 3, dans lequel les premières lignes (81) individuelles sont des fils de longueurs identiques, de sections transversales identiques et en matériaux identiques.

5. Agencement de semi-conducteurs suivant l'une quelconque des revendications 1 à 4, comprenant, en outre :
une multiplicité de premiers corps (1) semi-conducteurs ayant chacun l'un individuel d'une multiplicité d'éléments (T) semi-conducteurs commandables ; et
un deuxième corps (2) semi-conducteur ayant l'élément (F) de roue libre.

6. Agencement de semi-conducteurs suivant la revendication 5, comprenant, en outre, un support isolé électriquement ayant une métallisation structurée, les premiers corps (1) semi-conducteurs et le deuxième corps (2) semi-conducteur étant disposés sur la métallisation du support (3) et y étant fixés.

7. Agencement de semi-conducteurs suivant la revendication 6, dans lequel chacun des premiers corps (1) semi-conducteurs comprend :
une première plage de contact connectée électriquement à la première électrode (21) de l'élément (T) semi-conducteur commandable correspondant, disposée sur une surface du premier corps (1) semi-conducteur respectif, loin du support (3) ; et
une deuxième plage de contact, qui est connectée électriquement à au moins une partie de la métallisation structurée du support (3) et à la deuxième électrode de l'élément (T) semi-conducteur commandable correspondant.

8. Agencement de semi-conducteurs suivant la revendication 6 ou 7, dans lequel le deuxième corps (2) semi-conducteur comprend :
une première plage de contact connectée électriquement à la première électrode (21) de l'élément (F) de roue libre et disposée d'un côté du premier corps (2) semi-conducteur, loin du support (3) ; et
une deuxième plage de contact connectée électriquement à au moins une partie de la métallisation structurée du support (3) et à la deuxième électrode de l'élément (F) de roue libre.

9. Agencement de semi-conducteurs suivant la revendication 8, dans lequel la première plage de contact du deuxième corps semi-conducteur est connectée électriquement aux premières plages de contact des premiers corps semi-conducteurs par l'intermédiaire de fils distincts.

10. Agencement de semi-conducteurs suivant la revendication 8 ou 9, dans lequel la deuxième plage de contact du deuxième corps semi-conducteur est connectée électriquement aux deuxièmes plages de contact des premiers corps semi-conducteurs par l'intermédiaire d'au moins des parties de la métallisation du support (3).

11. Agencement de semi-conducteurs suivant l'une quelconque des revendications 1 à 10, dans lequel :
chacun des éléments (T) semi-conducteurs commandables a un élément (14) de roue libre intrinsèque, monté électriquement entre la première électrode (11) de charge et la deuxième électrode (12) de charge de l'élément (T) semi-conducteur commandable.

12. Agencement de semi-conducteurs suivant la revendication 11, dans lequel l'élément (14) de roue libre intrinsèque de chacun de la multiplicité d'éléments (T) semi-conducteurs commandables est une diode de corps de l'élément (T) semi-conducteur commandable correspondant.

13. Agencement de semi-conducteurs suivant la revendication 11 ou 12, dans lequel :
l'élément (F) de roue libre comprend une diode ayant une première tension directe ;
chacune des diodes de corps des éléments (T) semi-conducteurs commandables comprend une deuxième tension directe ; et
la deuxième tension directe est plus haute que la première tension directe.

14. Agencement de semi-conducteurs suivant l'une quelconque des revendications 1 à 13, dans lequel la quatrième borne est connectée électriquement à la première électrode (21) de l'élément (F) de roue libre par l'intermédiaire d'une troisième ligne distincte.

15. Agencement de semi-conducteurs suivant l'une quelconque des revendications 1 à 14, dans lequel chacun de la multiplicité d'éléments (T) semi-conducteurs commandables est un transistor à effet de champ à semi-conducteur métal oxyde ou un transistor bipolaire ou un transistor bipolaire à grille isolée.
